**Europäisches Patentamt**

**European Patent Office**

**Office européen des brevets**

(11) Veröffentlichungsnummer : **0 157 187**
**B1**

# EUROPÄISCHE PATENTSCHRIFT

(45) Veröffentlichungstag der Patentschrift :
17.05.89

(51) Int. Cl.⁴ : **H 03 F   3/38**, H 03 F   1/34

(21) Anmeldenummer : **85102374.7**

(22) Anmeldetag : **02.03.85**

(54) Verstärkerschaltung.

(30) Priorität : 21.03.84 CH 1415/84

(43) Veröffentlichungstag der Anmeldung :
09.10.85 Patentblatt 85/41

(45) Bekanntmachung des Hinweises auf die Patenterteilung : 17.05.89 Patentblatt 89/20

(84) Benannte Vertragsstaaten :
AT BE CH DE FR GB IT LI NL SE

(56) Entgegenhaltungen :
US--A-- 3 249 883
US--A-- 3 656 831
US--A-- 3 828 269

(73) Patentinhaber : **WILLI STUDER AG Fabrik für elektronische Apparate**
**Althardstrasse 30**
**CH-8105 Regensdorf ZH (CH)**

(72) Erfinder : **Zwicky, Paul**
**Channelstrasse 4**
**CH-8157 Dielsdorf ZH (CH)**

## Beschreibung

Die Erfindung betrifft eine verzerrungsarme Audio-Verstaerkerschaltung, bestehend aus einem Verstaerker und einem Quellenkreis, wobei der Quellenkreis eine Strom/Spannungsquelle aufweist und durch einen Uebertrager an den Verstaerker angeschlossen ist.

Solche Verstaerkerschaltungen haben die Aufgabe Audio-Signale moeglichst ohne Verzerrungen und bei kleinem Klirrfaktor zu verstaerken. Dabei entstehen Verzerrungen des Audio-Signales sowohl im Uebertrager wie auch im nachgeschalteten Verstaerker. Die durch den Verstaerker hervorgerufenen Verzerrungen lassen sich aber in bekannter Weise durch Massnahmen im und am Verstaerker vermeiden. Die vorgeschlagene Erfindung betrifft aber nicht die Vermeidung solcher durch den Verstaerker hervorgerufener Verzerrungen, sondern nur die durch den Uebertrager verursachten Verzerrungen.

Aus der US-Patentschrift US-A-3,828,269 ist eine solche Verstaerkerschaltung bekannt, bei der die magnetische Aussteuerung des Uebertragers sehr klein gehalten wird, um die Verzerrungen, die im Uebertrager verursacht werden moeglichst auszuschalten. Dies wird durch die Anordnung einer Gegenkopplung vom Ausgang des Verstaerkers in den Uebertrager erreicht. Der Uebertrager weist dementsprechend eine Gegenkopplungsspule auf. Die geringe magnetische Aussteuerung des Uebertragers induziert in der Spule des Quellenkreises eine geringe Spannung, was wiederum bewirkt, dass die Verstaerkerschaltung einen sehr geringen Eingangswiderstand aufweist.

Der Nachteil dieser Schaltung besteht darin, dass der Eingangswiderstand dieser Schaltung zu klein ist um Audio-Signale aus einer Signalquelle wie z. B. ein Mikrophon, damit verstaerken zu koennen. Die richtige Anpassung des Ausgangswiderstandes des Mikrophons an den Eingangswiderstand der Verstaerkerschaltung waere zwar denkbar, indem ein Widerstand in den Quellenkreis eingebaut wird, wodurch der Eingangswiderstand im gewuenschten Ausmass erhoeht wuerde. Diese Anpassung hat aber wiederum den Nachteil, dass ein solcher Widerstand Rauschen erzeugt, das nachfolgend im Verstaerker noch weiter verstaerkt wird und das bei Audio-Signalen unannehmbar ist.

Aus der US-Patentschrift US-A-3,656,831 ist eine Verstaerkerschaltung bekannt, bei der der Quellenkreis ueber zwei trifilar gewickelte Uebertrager an einen Verstaerkerkreis angeschlossen ist, dessen Ausgang auch wieder ueber einen Uebertrager angeschlossen ist. Der Verstaerkerkreis besteht im wesentlichen aus einem Hauptverstaerker und einem Fehlerverstaerker. Ziel dieser Anordnung ist es, die Verzerrungen zu korrigieren, die im Hauptverstaerker erzeugt werden. Diese Verstaerkerschaltung findet in der Traegerfrequenztechnik ihre Anwendung. Die Traegerfrequenztechnik betrifft die Uebertragung breitbandiger Signale in Leitungen.

Fuer die Verstaerkung von Audio-Signalen ist diese Verstaerkerschaltung ungeeignet, denn sie weist eine niedrige Eingangsimpedanz auf. Die Ausgangsimpedanz dagegen, die fuer Audio-Signale tief sein soll, kann bei einer solchen Verstaerkerschaltung nicht genuegend tief gehalten werden, da der Ausgangskreis und der eine der beiden Uebertrager im Quellenkreis in Serie liegen. Die Eingangsimpedanz und die Ausgangsimpedanz dieser Verstaerkerschaltung muss an die Impedanz der betreffenden Uebertragungsleitung angepasst sein, was bedeutet, dass sie gleich sind, doch dies ist fuer eine Audio-Verstaerkerschaltung nicht brauchbar.

Es ist ferner an sich bekannt, die Verzerrungen die ein Uebertrager erzeugt dadurch zu vermeiden, dass der Uebertrager gross und schwer ausgebildet wird. Doch diese Loesung ist im Zuge der Miniaturisierung elektronischer Anlagen nicht erwuenscht.

Die Erfindung, wie sie ausgehend von der US-A-3 656 831 in den Anspruechen gekennzeichnet ist, loest die Aufgabe, eine Audio-Verstaerkerschaltung zu schaffen, welche sich fuer Signalquellen mit grossem Dynamikbereich eignet und einen kleinen, leichten und billigen Uebertrager einzusetzen erlaubt, ohne dass dafuer Verzerrungen oder Rauschen in Kauf genommen werden muss.

Die durch die Erfindung erreichten Vorteile sind im wesentlichen darin zu sehen, dass in einer solchen Verstaerkerschaltung die Uebertrager so betrieben werden koennen, dass Nichtlinearitaeten der Kerne der Uebertrager nicht wirksam werden. Dadurch koennen die Uebertrager klein, leicht und billig ausgefuehrt werden. Mit einer solchen Anordnung koennen hohe Gleichtaktspannungen vom Verstaerker fern gehalten werden. Die vollstaendige Isolierung ermoeglicht eine individuelle Schutzerdung der zusammengeschalteten Apparate. Bei tiefen Frequenzen werden auf diese Weise Klirrfaktor-Werte erzielt, die um einen Faktor 101 bis 1 000 geringer sind als mit bekannten Loesungen mit vollstaendig isoliertem Quellenkreis. Das Eigenrauschen der Schaltung kann bei geeigneter Wahl der Komponenten verschwindend klein gemacht werden. Die verwendeten Uebertrager im Quellenkreis koennen ungefaehr viermal kleiner und leichter und sieben mal billiger ausgefuehrt werden, als wenn der Uebertrager zur Vermeidung der von ihm erzeugten Verzerrungen allein entsprechend dimensioniert werden muesste.

Im folgenden wird die Erfindung anhand von lediglich einen Ausfuehrungsweg darstellenden Zeichnungen naeher erlaeutert. Es zeigen :.

Figur 1 eine erste Ausfuehrungsform einer erfindungsgemaessen Audio-Verstaerkerschaltung und die

Figuren 2, 3, 4, 5, 6 und 7 je eine weitere Ausfuehrungsform der Verstaerkerschaltung gemaess Figur 1.

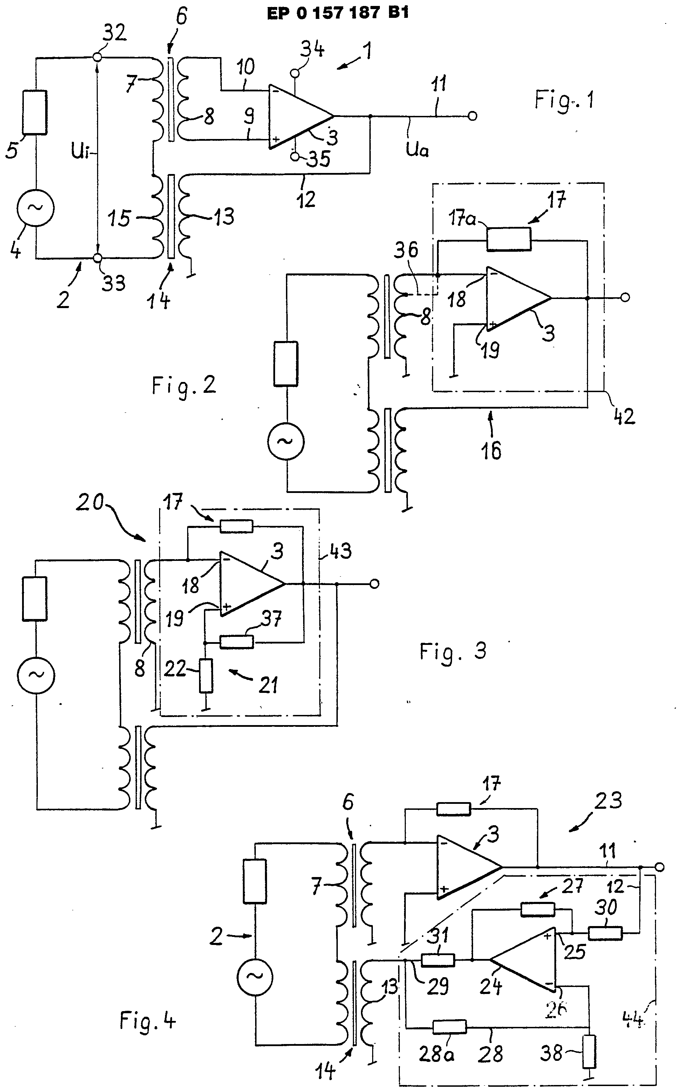

Aus Figur 1 ist eine Verstaerkerschaltung 1 mit einem Quellenkreis 2 und einem Verstaerker 3 ersichtlich. Der Quellenkreis 2 besteht aus einer Strom/Spannungsquelle 4 und einem Widerstand 5. Als Strom/Spannungsquelle 4 kann beispielsweise ein elektromechanischer Wandler wie z. B. ein Mikrophon oder eine andere Signalquelle vorgesehen sein. Ein Uebertrager 6 stellt die Verbindung zwischen dem Verstaerker 3 und der Strom/Spannungsquelle 4 her. Dessen Primaerwicklung 7 liegt dabei im Quellenkreis 2, dessen Sekundaerwicklung 8 ist ueber Leitungen 9 und 10 an den Verstaerker 3 angeschlossen, so dass die Leitungen 9, 10 und die Sekundaerwicklung 8 zusammen mit dem Verstaerker 3 einen Eingangskreis bilden. Der Verstaerker 3 besitzt in an sich bekannter Weise Anschluesse 34 und 35 fuer eine Speisung. Ein Ausgang 11 des Verstaerkers 3 ist ueber eine Leitung 12 mit der Primaerwicklung 13 eines weiteren Uebertragers 14 verbunden, dessen Sekundaerwicklung 15 im Quellenkreis 2 in Serie zur Primaerwicklung 7 des Uebertragers 6 liegt. Die Leitung 12 bildet zusammen mit dem weiteren Uebertrager 14 eine Gegenkopplung fuer den Verstaerker 3.

Im Quellenkreis 2 hat die Sekundaerspule 15 die Aufgabe eine Gegenspannung zu bilden zu einer Spannung Ui wie sie zwischen Klemmen 32 und 33 auftritt. Diese Gegenspannung wiederum ist durch eine Ausgangsspannung Ua erzeugt, wie sie am Ausgang 11 des Verstaerkers 3 auftritt und somit an die Primaerwicklung 13 des weiteren Uebertragers 14 angelegt ist. Durch diese Anordnung wird die Eingangsimpedanz des Quellenkreises 2 hoch. Da die Verstaerkerschaltung 1 nur kleine Kupferwiderstaende von Spulen aufweist, die zu den Uebertragern 6 und 14 gehoeren, ist sie rauscharm. Der Verstaerker 3 weist eine grosse Verstaerkung auf. Das erlaubt eine kleine Spannung ueber der Sekundaerspule 8, was bedeutet, dass der Uebertrager 6 magnetisch nur sehr wenig ausgesteuert wird und somit auch nur wenig Verzerrungen erzeugt. Der weitere Uebertrager 14 erzeugt nur kleine Verzerrungen, weil seine Primaerwicklung 13 durch eine konstante Spannung Ua betrieben wird. Die durch die grosse magnetische Aussteuerung des Uebertragers 14 notwendigen nichtlinearen Magnetisierungsstroeme werden vom Verstaerker 3 aufgebracht, ohne dass dabei die Ausgangsspannung Ua nichtlinear wird. Somit kann der Uebertrager 14 so betrieben werden, dass die Magnetisierung des Kerns im Uebertrager 14 nahe an die Saettigung geht. Somit kann fuer den weiteren Uebertrager 14 wie fuer den Uebertrager 6 ebenfalls eine kleine, leichte und billige Ausfuehrung gewaehlt werden.

Ist die Verstaerkung des Verstaerkers 3 nicht genuegend gross, so wird die Spannung ueber der Sekundaerspule 8 des Uebertragers 6 nicht so klein, dass die Verzerrungen die der Uebertrager 6 erzeugt klein genug sind. Es kann auch vorkommen, dass bei genuegend grosser Verstaerkung stoerende Schwingungen im Eingangskreis auftreten. Beides wird in einer Verstaerkerschaltung 16 verhindert.

In Figur 2 ist eine Verstaerkerschaltung 16 dargestellt, die sich gegenueber der Verstaerkerschaltung 1 dadurch unterscheidet, dass der Verstaerker 3 eine Rueckkopplung 17 auf seinen invertierenden Eingang 18 aufweist. Weiter ist die Sekundaerwicklung 8 und der nichtinvertierende Eingang 19 des Verstaerkers 3 auf Erde geschaltet. Der Verstaerker 3 bildet zusammen mit seiner Rueckkopplung 17 eine Verstaerkereinheit 42.

Prinzipiell hat der Verstaerker 3 in an sich bekannter Weise eine sehr hohe Eingangsimpedanz. Diese ist bei Operationsverstaerkern allgemein ueblich. Sie kann beliebig klein gemacht werden, indem man einen Widerstand 17a als Gegenkopplung einfuehrt. Die Eingangsimpedanz der Verstaerkereinheit 42 ist gleich dem Wert des Widerstandes 17a geteilt durch die Verstaerkung des nicht gegengekoppelten Verstaerkers 3. Wird die Eingangsimpedanz dieser Verstaerkereinheit 42 vernachlaessigbar klein gemacht, so arbeitet der Uebertrager 6 mit seiner Sekundaerwicklung 8 auf einen scheinbaren Kurzschluss. Die induzierte Spannung im Kern des Uebertragers 6 ist deshalb verschwindend klein. Dadurch werden auch keine Verzerrungen erzeugt.

Um moeglichst wenig Rauschen zu erhalten, ist es vorteilhaft, die Rueckkopplung 17 auf einen Abgriff 36 der Sekundaerwicklung 8 zurueckzufuehren.

In Figur 3 ist eine Verstaerkerschaltung 20 ersichtlich, in welcher der Verstaerker 3 je eine Rueckkopplung 17 und 21 auf beide Eingaenge 18 und 19 aufweist. Der nichtinvertierende Eingang 19 ist ueber einen Widerstand 22 auf Erde geschaltet. Der Verstaerker 3 mit den Rueckkopplungen 17 und 21 bildet eine Verstaerkereinheit 43.

Durch entsprechende Dimensionierung der Rueckkopplungen 17 und 21 kann die Eingangsimpedanz der Verstaerkereinheit 43 nicht nur zu Null, sondern auch negativ gemacht werden. Dadurch kann z. B. der Kupferwiderstand der Sekundaerwicklung 8 des Uebertragers 6 teilweise oder sogar vollstaendig kompensiert werden, was die Verzerrungen die der Uebertrager 6 erzeugt weiter vermindert. Damit dies erreicht ist, gilt :

$$Zcu = -R\,17\, \frac{R\,22}{R\,22 + R\,37}$$

wobei R Widerstandswerte der Widerstaende 17, 22 und 37 gemaess Figur 3 und Zcu der Kupferwiderstand der Sekundaerspule 8 bedeuten.

Der weitere Uebertrager 14 kann dann gewisse Verzerrungen erzeugen, wenn der nichtlineare Magnetisierungsstrom am Kupferwiderstand der Primaerspule 13 des weiteren Uebertragers 14 einen nichtlinearen Spannungsabfall erzeugt. Dadurch wird die in den Quellenkreis 2 induzierte Spannung verfaelscht. Diesem Nachteil kann mit einer Verstaerkerschaltung 23 gemaess Figur 4 begegnet werden.

Eine Verstaerkerschaltung 23 gemaess Figur 4 weist einen Verstaerker 3 mit Rueckkopplung 17 auf.

3

Die Gegenkopplung vom Ausgang 11 ueber den Uebertrager 14 auf den Quellenkreis 2 besteht dabei aus einem Verstaerker 24, dessen beide Eingaenge 25 und 26 je eine Rueckkopplung 27 und 28 von dessen Ausgang 29 erhalten und der weiter einen Eingangswiderstand 30 und einen Widerstand 31 aufweist. Die Rueckkopplung 28 weist dabei vorzugsweise einen Widerstand 28a auf und ist ueber einen weiteren Widerstand 38 mit der Erde verbunden. Sie kann aber auch nur aus einer Leitung bestehen. Der Verstaerker 24 mit seinen Rueckkopplungen 27 und 28 und seinen allfaelligen Widerstaenden 30, 31 bildet eine Verstaerkereinheit 44.

Waehrend in den Verstaerkerschaltungen 1, 16 und 20 die Primaerwicklung 13 des weiteren Uebertragers 14 durch eine konstante Spannung betrieben wird, was bedeutet, dass die Quellenimpedanz des Verstaerkers 3 Null ist, wird die entsprechende Primaerspule 13 der Verstaerkerschaltung 23 durch eine Quelle d. h. die Verstaerkereinheit 44 mit einer negativen Quellenimpedanz Z betrieben. Diese betraegt :

$$Z = -R\,31\,\frac{1 + R\,28\,a/R\,38}{R\,27/R\,30 - R\,28\,a/R\,38}$$

Dabei bedeuten R die Werte der einzelnen beteiligten Wider staende. Durch eine Dimensionierung derart, dass die negative Quellenimpedanz Z der Verstaerkereinheit 44 gerade den Kupferwiderstand der Primaerspule 13 des weiteren Uebertragers 74 kompensiert, wird erreicht, dass der nichtlineare Magnetisierungsstrom in der Primaerwicklung 13 keinen Spannungsabfall mehr erzeugt. Damit wird die induzierte Spannung im weiteren Uebertrager 14 verzerrungsfrei. Zur Erzeugung der genannten negativen Quellenimpedanz sind auch andere Ausfuehrungen fuer die Verstaerkereinheit 44 denkbar. Eine davon ist in der Europaeischen Patentanmeldung 0 041 472 beschrieben.

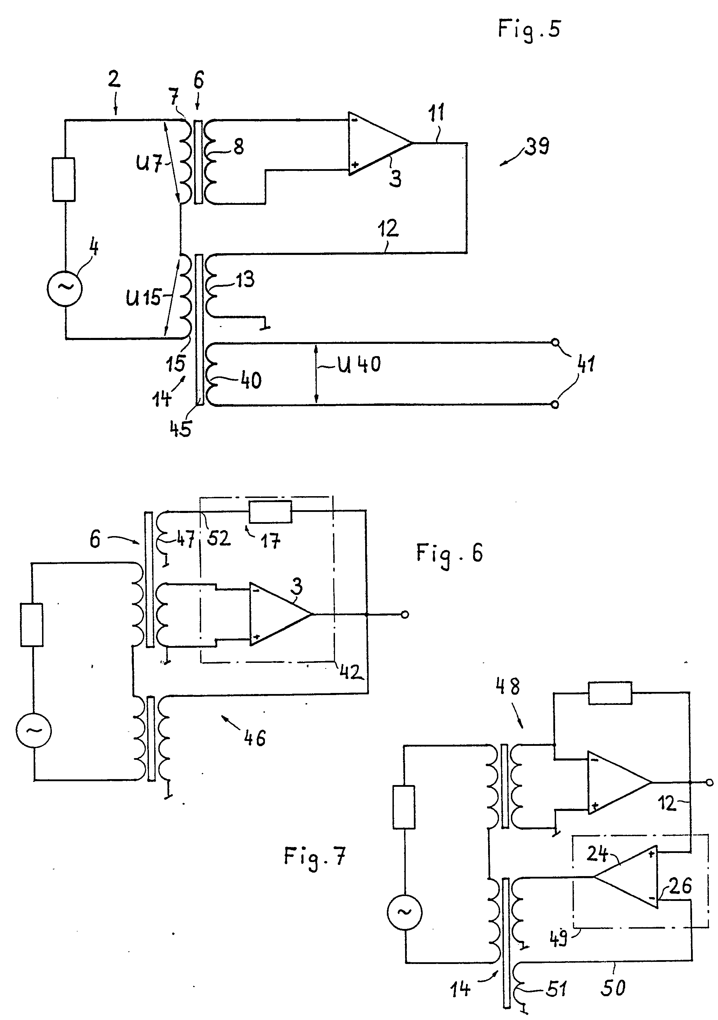

Figur 5 zeigt eine weitere Verstaerkerschaltung 39 mit dem Quellenkreis 2 und den zwei Uebertragern 6 und 14. Der Uebertrager 14 weist eine weitere Spule 40 auf, die mit einem Ausgang 41 verbunden ist. Der Verstaerker 3 ist in bekannter Weise an die Sekundaerspule 8 angeschlossen. Die Leitung 12 verbindet den Ausgang 71 des Verstaerkers 3 mit der einseitig geerdeten Primaerspule 73 des Uebertragers 14.

Bei dieser Verstaerkerschaltung 39 wird die Ausgangsspannung des Verstaerkers 3 ueber die Leitung 12 und die Primaerspule 13 in den Quellenkreis 2 zurueckgefuehrt. Die Spule 40 greift diese Ausgangsspannung wieder ab und stellt sie dem Ausgang 41 zur Verfuegung.

Bei der Verstaerkerschaltung 39 wird zunaechst durch schon beschriebene Massnahmen dafuer gesorgt, dass der erste Uebertrager 6 verzerrungsfrei arbeitet. In allen beschriebenen Faellen, wird eine Spannung U7 ueber der Primaerspule 7 verschwindend klein. Das bedeutet, dass eine Spannung U15 ueber der Sekundaerspule 15 des weiteren Uebertragers 14 praktisch gleich gross wird, wie die Spannung Ui im Quellenkreis 2 (Fig 1). Da die Spannung U15 durch die Magnetisierung des Kernes 45 des weiteren Uebertragers 14 erzeugt wird, folgt, dass die induzierte Spannung U40 in der Spule 40 der Spannung U15 proportional ist. Da Ui = U15 und U40 proportional zu U15 ist, ergibt sich, dass U40 proportional zu der Spannung Ui ist. Damit ist eine Verzerrung durch den weiteren Uebertrager 14 ausgeschlossen.

Alle genannten Anordnungen zur Vermeidung von Verzerrungen in den Uebertragern 6 und 14 sind beliebig miteinander kombinierbar. Insbesondere durch Kombination der Verstaerkerschaltungen 20 und 23 lassen sich die Kupferwiderstaende sowohl der Sekundaerspule 8 wie auch der Primaerspule 13 zusammen ausgleichen. Dies ergibt eine besonders verzerrungsarme und rauscharme Verstaerkerschaltung.

. Figur 6 zeigt eine Verstaerkerschaltung 46, welche lediglich als weitere Variante der Verstaerkerschaltung 16 (Fig 2) zu betrachten ist. Bei dieser Verstaerkerschaltung 46 wird die Rueckkopplung 17 mit einer weiteren Spule 47 in den Uebertrager 6 zurueckgefuehrt. Ein Ausgang 52 der Verstaerkereinheit 42 ist als Anschluss fuer die Rueckkopplung 17 an die weitere Spule 47 vorgesehen. In dieser Verstaerkerschaltung 46 wird die magnetische Aussteuerung des Kernes des Uebertragers 6 durch den Strom in der weiteren Spule 47 zu Null gebracht. Dadurch entfallen die Verzerrungen.

Figur 7 zeigt eine Verstaerkerschaltung 48 mit einer Verstaerkereinheit 49 in der Gegenkopplung wobei der invertierende Eingang 26 des Verstaerkers 24 ueber eine Leitung 50 mit einer weiteren Spule 51 im weiteren Uebertrager 14 verbunden ist. Durch Gegenkopplung der induzierten Spannung in der weiteren Spule 51 werden nichtlineare Magnetisierungsstroeme unwirksam. Dadurch werden die Verzerrungen sehr gering.

Der erste Uebertrager 6 ist in diesen Verstaerkerschaltungen in bekannter Weise abzuschirmen. Seine dank der Erfindung stark verminderten Dimensionen erleichtern dies aber erheblich. Da der weitere Uebertrager 14 durch den Verstaerker 3 spannungskontrolliert ist, wird er von Fremdfeldern nicht beeinflusst. Eine Abschirmung des Uebertragers 14 ist deshalb nicht noetig.

## Patentansprüche

1. Verzerrungsarme Audio-Verstaerkerschaltung, bestehend aus einem Verstaerker (3) und einem Quellenkreis (2), bei der der Quellenkreis eine Spannungsquelle (4) mit einem Quellenwiderstand (5) aufweist und durch einen Uebertrager (6) an den Verstaerker (3) angeschlossen ist, bei der ferner mit der im Quellenkreis liegenden Wicklung (7) des Uebertragers (6) eine Quellenkreiswicklung (15) eines weiteren Uebertragers (14) in Serie geschaltet ist, und der Verstaerker eine Gegenkopplung aufweist, dadurch gekennzeichnet, dass die Gegenkopplung ueber den weiteren Uebertrager (14) in den Quellenkreis (2) derart zurueckgefuehrt ist, dass an der Quellenkreiswicklung (15) im weiteren Uebertrager (14) eine Spannung auftritt, die weitgehend die Spannung der Spannungsquelle (4) aufhebt und dass nur noch ein kleiner Teil der Spannung der Spannungsquelle (4) fuer den Quellenwiderstand (5) oder den einen Uebertrager (6) bleibt, wodurch im Quellenkreis eine Erhoehung der Eingangsimpedanz der Audio-Verstaerkerschaltung bewirkt wird.

2. Verstaerkerschaltung gemaess Anspruch 1, dadurch gekennzeichnet, dass der Verstaerker (3) Teil einer Verstaerkereinheit (42, 43) ist.

3. Verstaerkerschaltung gemaess Anspruch 2, dadurch gekennzeichnet, dass die Verstaerkereinheit (42) eine vernachlaessigbar kleine Eingangsimpedanz aufweist.

4. Verstaerkerschaltung gemaess Anspruch 2, dadurch gekennzeichnet, dass die Verstaerkereinheit (43) eine negative Eingangsimpedanz aufweist, welche den Kupferwiderstand der Sekundaerwicklung (8) des Uebertragers (6) mindestens teilweise kompensiert.

5. Verstaerkerschaltung gemaess Anspruch 1, dadurch gekennzeichnet, dass die Gegenkopplung eine weitere Verstaerkereinheit (44, 49) aufweist, dessen Ausgang mit der Primaerspule (13) des weiteren Uebertragers (14) und dessen Eingang (25) mit dem Ausgang (11) des Verstaerkers (3) verbunden ist.

6. Verstaerkerschaltung gemaess Anspruch 5, dadurch gekennzeichnet, dass die weitere Verstaerkereinheit (44) eine negative Quellenimpedanz aufweist, die den Kupferwiderstand der Primaerspule (13) des weiteren Uebertragers (14) mindestens teilweise kompensiert.

7. Verstaerkerschaltung gemaess Anspruch 1, dadurch gekennzeichnet, dass der weitere Uebertrager (14) eine weitere Spule (40) aufweist, die den Ausgang (41) der Verstaerkerschaltung bildet.

8. Verstaerkerschaltung gemaess Anspruch 2, dadurch gekennzeichnet, dass die Verstaerkereinheit (42) ueber einen weiteren Ausgang (52) fuer eine Rueckkopplung (17) mit einer weiteren Spule (47) im Uebertrager (6) verbunden ist.

9. Verstaerkerschaltung gemaess Anspruch 5, dadurch gekennzeichnet, dass der weitere Eingang (26) des Verstaerkers (24) der weiteren Verstaerkereinheit (49) mit einer weiteren Spule (51) im weiteren Uebertrager (14) verbunden ist.

10. Verstaerkerschaltung gemaess Anspruch 2 oder 5, dadurch gekennzeichnet, dass die Verstaerkereinheit (42, 43) und die weitere Verstaerkereinheit (44) jeweils eine negative Rueckkopplung (17, 28) auf den jeweiligen invertierenden Eingang (18, 26) aufweisen.

11. Verstaerkerschaltung gemaess Anspruch 10, dadurch gekennzeichnet, dass die weitere Verstaerkereinheit (44) und die Verstaerkereinheit (43) jeweils eine positive Rueckkopplung (27, 21) auf den jeweiligen nichtinvertierenden Eingang (25, 19) aufweisen.

## Claims

1. Low-distortion audio amplifier circuit arrangement comprising an amplifier (3) and a source circuit (2), said source circuit containing a current-voltage source (4) and a resistor (5) and being connected to the amplifier (3) by means of a transformer (6), said source circuit (2) comprising a secondary winding (7) of the transformer (6) and a secondary winding (15) of a further transformer (14) both connected in series, and said amplifier (3) comprising a feedback circuit, characterized in that said feedback circuit is coupled back to said source circuit (2) via the further transformer (14) in such a way that a voltage is produced in the secondary winding (15) of the further transformer (14) which nearly nullifies the voltage of the current voltage source (4) and that only a small part of the voltage of the current voltage source (4) remains for the resistance (5) or the transformer (6), whereby the input impedance of the audio amplifier circuit arrangement is increased in the source circuit (2).

2. Amplifier circuit arrangement in accordance with claim 1, characterized in that said amplifier (3) constitutes a component of an amplifier unit (42, 43).

3. Amplifier circuit arrangement in accordance with claim 2, characterized in that said amplifier unit (42) possesses a negligibly low input impedance.

4. Amplifier circuit arrangement in accordance with claim 2, characterized in that said amplifier unit (43) possesses a negative input impedance which at least partially compensates said winding resistance of said secondary winding (8) of transformer (6).

5. Amplifier circuit arrangement in accordance with claim 1, characterized in that said feedback circuit possesses a further amplifier unit (44, 49), said amplifier unit having an output connected to the primary winding (13) of the further transformer (14) and having an input (25) connected to the output (11) of the amplifier (3).

6. Amplifier circuit arrangement in accordance with claim 5, characterized in that said further amplifier unit (44) possesses a negative source impedance which at least partially compensates said winding resistance of said primary winding (13) of the further transformer (14).

7. Amplifier circuit arrangement in accordance with claim 1, characterized in that said further transformer (14) comprises an additional winding (40) constituting the output of the amplifier circuit arrangement.

8. Amplifier circuit arrangement in accordance with claim 2, characterized in that said amplifier unit (42) possesses an output (52) and a feedback circuit (17) both connected to an additional winding (47) of said transformer (6).

9. Amplifier circuit arrangement in accordance with claim 5, characterized in that said amplifier unit (49) comprises an amplifier (24) having an input (26) being connected to an additional winding (51) in the further transformer (14).

10. Amplifier circuit arrangement in accordance with claim 2 or 5, characterized in that amplifier units (42, 43) and said further amplifier unit (44) comprise a negative feedback circuit (17, 28) being connected to inverting inputs (18, 26) of said amplifier unit.

11. Amplifier circuit arrangement in accordance with claim 10, charaterized in that said further amplifier unit (44) and said amplifier unit (43) comprise a positive feedback circuit (27, 21) being connected to non-inverting inputs (25, 19) of said amplifier unit.

**Revendications**

1. Circuit amplificateur audio à faible distorsion se composant d'un amplificateur (3) et d'un circuit de source (2) où ce circuit de source contient une source (4) de courant et de tension ainsi qu'une résistance (5) de source et est relié par un transformateur (6) à l'amplificateur (3), où un enroulement (15) faisant partie du circuit de source et d'un autre transformateur (14) est relié en série à un enroulement (7) du transformateur (6) faisant partie du circuit de source et où l'amplificateur est pourvu d'une boucle de réaction, caractérisé en ce que la boucle de réaction est ramené dans le circuit de source (2) par l'autre transformateur (14) de telle manière que l'enroulement (15) de l'autre transformateur (14) faisant partie du circuit de source est soumis une tension qui compense en large mesure la tension crée par la source (4) et qu'une petite partie de la tension crée par la source (4) reste appliquée à la résistance (5) ou au transformateur (6), afin d'augmenter l'impédance d'entrée dans le circuit de source du circuit amplificateur audio.

2. Circuit amplificateur selon la revendication 1, caractérisé en ce que l'amplificateur (3) fait partie d'une unité d'amplification (42, 43).

3. Circuit amplificateur selon la revendication 2, caractérisé en ce que l'unité d'amplification (42) a une impédance d'entrée négligeable.

4. Circuit amplificateur selon la revendication 2, caractérisé en ce que l'unité d'amplification (43) a une impédance d'entrée négative qui compense au moins partiellement la résistance du cuivre de l'enroulement secondaire (8) du transformateur (6).

5. Circuit amplificateur selon la revendication 1, caractérisé en ce qu'une autre unité d'amplification (44, 49) dont la sortie est reliée à l'enroulement primaire (13) de l'autre transformateur (14) et dont l'entrée (25) est reliée à la sortie (11) de l'amplificateur (3) fait partie de la boucle de réaction.

6. Circuit amplificateur selon la revendication 5, caractérisé en ce que l'autre unité d'amplification (44) produit une impédance de source négative qui compense au moins en partie la résistance du cuivre de l'enroulement primaire (13) de l'autre transformateur (14).

7. Circuit amplificateur selon la revendication 1, caractérisé en ce que l'autre transformateur (14) contient un autre enroulement (40) qui forme la sortie (41) du circuit amplificateur.

8. Circuit amplificateur selon la revendication 2, caractérisé en ce que l'unité d'amplification (42) est reliée à un autre enroulement (47) dans le transformateur (6) par une autre sortie (52) pour former une boucle de réaction.

9. Circuit amplificateur selon la revendication 5, caractérisé en ce que l'entrée (26) de l'amplificateur (24) de l'unité d'amplification (49) est relié à un autre enroulement (51) dans l'autre transformateur (14).

10. Circuit amplificateur selon la revendication 2 ou 5, caractérisé en ce que l'unité d'amplification (42, 43) et l'autre unité d'amplification (44) ont chacune une boucle de réaction négative (17, 28) aboutissant à l'entrée inversée (18, 26).

11. Circuit amplificateur selon la revendication 10, caractérisé en ce que l'unité d'amplification (43) et l'autre unité d'amplification (43) ont chacune une boucle de réaction positive (27, 21) aboutissant à l'entrée non inversée (19).

Fig. 1

Fig. 2

Fig. 3

Fig. 4

Fig. 5

Fig. 6

Fig. 7